Europäisches Patentamt

European Patent Office

Office européen des brevets

(11) Publication number: **0 037 663**
**B1**

(12) **EUROPEAN PATENT SPECIFICATION**

(45) Date of publication of patent specification: **11.06.86**     (51) Int. Cl.⁴: **G 03 B 41/00**

(21) Application number: **81301198.8**

(22) Date of filing: **19.03.81**

(54) **Method and apparatus for positioning a wafer on a flat bed.**

(30) Priority: **02.04.80 US 136745**

(43) Date of publication of application:
**14.10.81 Bulletin 81/41**

(45) Publication of the grant of the patent:
**11.06.86 Bulletin 86/24**

(84) Designated Contracting States:
**DE FR GB IT NL SE**

(56) References cited:
**FR-A-2 033 713**
**FR-A-2 219 398**
**US-A-3 899 634**
**US-A-4 163 212**

(73) Proprietor: **GENERAL SIGNAL CORPORATION**
**PO Box 10010 High Ridge Park**
**Stamford Connecticut 06904 (US)**

(72) Inventor: **Fujimoto, Stanley M.**
**486 Cheyenne Lane**
**San Jose California 95123 (US)**

(74) Representative: **Baillie, Iain Cameron et al**
**c/o Ladas & Parry Isartorplatz 5**
**D-8000 München 2 (DE)**

Courier Press, Leamington Spa, England.

## Description

This invention relates to methods of, and apparatus for, performing precision operations on the dies of semiconductor wafers. More particularly, the invention relates to methods of, and apparatus for, providing such operations with greater precision and reliability than in the prior art.

The field of semiconductors has been rapidly advanced during the past few decades since the development of the semiconductor. For example, the amount of electrical circuitry capable of being provided on a die of a particular size has been progressively decreased. Furthermore, the methods of manufacturing the semiconductor have been considerably advanced and refined. As a result, semiconductors now contain much more sophisticated circuitry, in spite of their significantly reduced size, than the semiconductors of previous years. In spite of this sophistication, the prices now charged for semiconductors is quite low in comparison to prices charged in previous years.

The semiconductors are formed on wafers, each of which contains a plurality of dies with electrical circuitry printed on the dies. As the semiconductors have decreased in size and increased in sophistication, it has become progressively difficult to test properly the electrical circuitry on the individual dies on each wafer. A considerable effort has been made to keep pace with the advances in the semiconductor technology in the methods of, and apparatus for, testing semiconductors on the dies of each wafer. However, such efforts have not been entirely successful.

U.S. Patents Numbers 3,899,634 and 4,163,212 as well as French Patent 2,219,398 exemplify the state of the art in this respect. However, none of these prior patent discloses or even suggests the present invention. United States Patent 3,899,634 senses a coincidence of a video signal of an article and a video signal of a boundary marker to move the article until the video signal of the article and the video signal of the boundary marker do not coincide. By thus positioning the video signals of the article within the boundaries of a pair of coordinate axes such as X and Y axes, it is hoped that the article is properly positioned to obtain a scan. Soon a method of positioning a die is not as precise as that of the present invention since the die can still be skewed relative to the test probes. Furthermore, the boundary of the article may not be precise since the test pattern assumes that the article has a black border defining the boundary. This is not often true since there is different white information at different positions along the boundary. U.S. Patent 4,163,212 scans a "blob" in at least two perpendicular directions to locate the center of the block. Scanning in two coordinate directions is sometimes not enough depending upon the characteristics of the blob. It is then necessary to scan in two other directions which are coordinate with each other and which are transverse relative to the first pair of coordinate directions. A blob does not constitute the best material to be scanned. One reason is that it is all black or it is white with a black border. Furthermore, it can have any odd irregular shape. As a result, it is difficult to determine the center of the blob. For these reasons, a blob certainly does not provide the distinctiveness obtained by the present invention in the distinctive portion.

According to the present invention there is provided a method of positioning each wafer of a plurality of wafers, using a flat bed for supporting the wafer to perform precision operations on the wafer thereafter where each of the wafers in the plurality has a plurality of printed dies disposed in at least one row and each die in the at least one row has a corresponding image, characterized by the following steps:

i) placing a first wafer on the flat bed,

ii) scanning an image of a particular wafer portion comprising at least a part of one die to use as a reference portion distinctive in image structure from portions around the reference portion and providing and storing an indication of the distinctiveness of the image structure of the reference portion relative to the portions around it,

iii) aligning the row of dies along a particular axis by comparison of the distinctiveness of the image structure of the reference portion with that of a corresponding portion of another die of the row and angularly displacing the wafer until the distinctiveness of the reference portion and the said corresponding portion are substantially corresponding,

iv) moving the wafer to a starting position by adjusting the flat bed position and storing the coordinates of the starting position with respect to the coordinates of the position of the reference portion,

v) performing the precision operations on at least one die of the wafer,

vi) removing the first wafer and placing a second one on the flat bed,

vii) scanning an image of a portion of the second wafer approximately corresponding to the said reference portion and providing and storing an indication of the distinctiveness of the image structure of the scanned portion,

viii) comparing the distinctiveness of the image structure of the scanned portion with the distinctiveness of the image structure of the reference portion,

ix) adjusting the position of the second wafer by adjusting the flat bed position to obtain a substantial correspondence between the distinctiveness of the image structures of the reference portion and the portion being scanned on the second wafer,

x) aligning the wafer according to iii),

xi) displacing the second wafer to the starting position in accordance with the stored coordinates of the starting position,

xii) performing the precision operations on at least one die on the second wafer,

xiii) repeating steps vi) to xii) for each wafer of the plurality of wafers.

According to a further aspect of the invention there is provided an apparatus for carrying out the above method, characterized by

i) means for placing a first wafer on the flat bed,

ii) means for scanning the reference portion of the first wafer and the portions around the reference portion and for determining the image structure of the reference portions and the portions around the particular portions,

iii) means for comparing the image structure of the reference portion with those of the portions around the reference portion to establish the distinctiveness of the image structure of the reference portion,

iv) means for storing the said distinctiveness of the image structure of the reference portion,

v) means for comparing the distinctiveness of the image structure of the reference portion with the distinctiveness of the image structure of the corresponding portion of the dies in the row displaced from the reference portion,

vi) means for rotating the first wafer to make the distinctiveness of the image structure of the displaced portion correspond with the distinctiveness of the image structure of the reference portion,

vii) means for obtaining a movement of the first wafer to the starting position,

viii) means for storing the coordinates of the starting position with respect to the coordinates of the position of the reference portion,

ix) means for removing the first wafer from the flat bed, and placing on the flat bed each of the successive wafers in the plurality,

x) means for scanning an image of a portion on each of the successive wafers approximately corresponding to the said reference portion and for storing an indication of the distinctiveness of the image structure of the scanned portion,

xi) means for comparing the distinctiveness of the image structure of the portion scanned on each of the successive wafers in the plurality with the distinctiveness of the image structure stored from the first wafer and for adjusting the position of the portion being scanned on each of the successive wafers to obtain a substantial correspondence in the distinctiveness of the image structure between the portion being scanned on such wafer and the reference portion on the first wafer,

xii) means for rotating the successive wafers according to vi),

xiii) means for moving the flat bed to the starting position for each of the successive wafers in the plurality in accordance with the stored coordinates representing the difference in coordinates between the position of the reference portion and the starting position on the first wafer,

xiv) means for moving the flat bed to successive dies on each of the wafers in the plurality, and

xv) means for obtaining a precision operation on each of the successive dies on each of the successive wafers in the plurality.

The invention preferably uses video techniques to obtain such advanced methods and apparatus. Such video techniques provide for the selection of a distinctive area as a preselected reference area and for the use of this reference area in progressively positioning the individual dies on each wafer precisely to test the electrical circuitry on the individual dies on the wafer.

As a first step in the method, a distinctive portion of a first wafer is chosen. The distinctiveness of the portion is verified by visually comparing the distinctive portion to portions intermediate to the distinctive portion and disposed around the distinctive portion. The distinctive portion is then compared with progressive portions on the wafer along a particular axis to determine rotary deviations of the wafer from disposition along the particular axis. Corrections are then made in the rotary disposition of the wafer in accordance with such comparisons. The displacement of such distinctive portion from a starting position on the wafer is then determined.

Each progressive wafer in the plurality is then sequentially selected for the precision operation. The distinctive portion on each wafer is initially selected and is subsequently confirmed by comparing the distinctive portion with the intermediate portions around the distinctive portion. The distinctive portion is then compared with progressive portions on the wafer along the particular axis to determine any rotary deviations of the wafer from disposition along the particular axis. Corrections are then made in the rotary deviation of each progressive wafer from disposition along the particular axis.

Each progressive wafer is then displaced to the starting position. The precision operation is thereafter performed sequentially on the different dies on each progressive wafer and the wafer is advanced to the next one of the progressive dies upon each such completion of such precision operation. Such precision operation may constitute the testing of electrical circuitry on the dies to determine if such circuitry has preselected characteristics.

The invention, together with features and advantages thereof, will best be understood from consideration of the following detailed description of exemplary embodiments which are illustrated in the accompanying drawings wherein:—

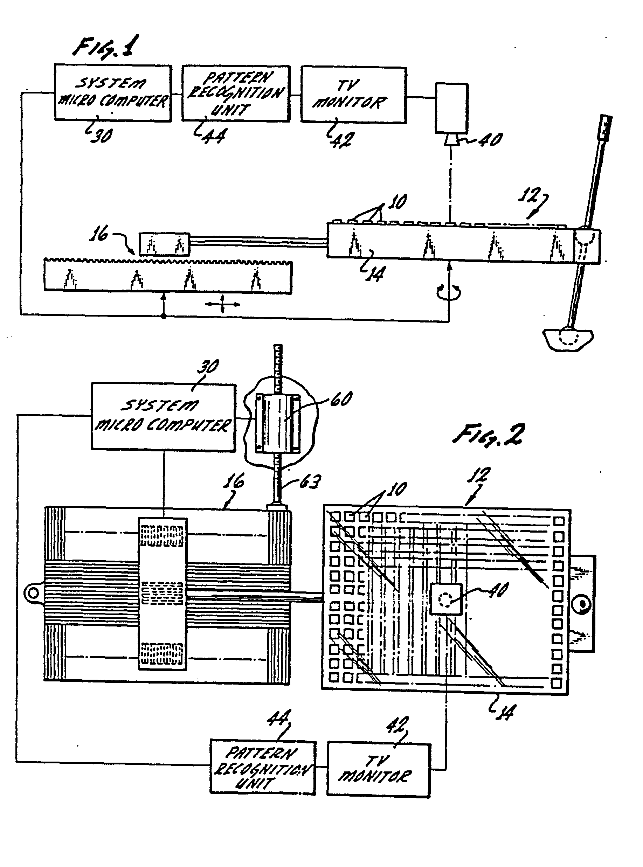

Figure 1 is a schematic elevational view of apparatus constituting one embodiment of the system constituting this invention and illustrates in block form certain electrical features of this system;

Figure 2 is an elevational view schematically illustrating certain additional features of the system constituting this invention;

Figure 3 is an enlarged fragmentary perspective view of certain of the features shown in Figure 2;

Figure 4 is an enlarged fragmentary perspective view, similar to that shown in Figure 3, schematically illustrating certain steps in the method constituting this invention;

Figure 5 is a fragmentary elevational view, even more enlarged than Figure 3, of certain features in the system and illustrates in block form certain additional electrical features of the system;

Figure 6 is an elevational view schematically illustrating an arrangement included in the system of this invention for testing the operability of dies on a wafer after the dies have been properly positioned by the system constituting this invention;

Figure 7 is an enlarged fragmentary elevational view similar to that shown in Figure 5 and illustrates schematically certain progressive testing operations by the system constituting this invention;

Figure 8 is a view illustrating a modification in the operation of the system when the dies on the wafer are relatively large; and

Figure 9 is a view illustrating another embodiment of the invention.

In one embodiment of the invention, apparatus is provided for performing precision operations on a plurality of dies 10 which are disposed in rows and columns on a wafer generally indicated at 12. For example, the precision operation may involve the testing of the electrical circuitry on each of the dies to determine if the electrical circuitry has been constructed properly.

The embodiment of this invention includes a flat bed 14 for receiving sequentially each of the progressive wafers 12 in the plurality. A precision motor generally indicated at 16 is operatively coupled to the flat bed 14 for driving the flat bed 14 in first and second coordinate directions such as along the X and Y axes. The motor 16 may be constructed in a manner similar to that disclosed and claimed in United States Patent No. 3,851,196 issued to Walter E. Hinds on November 26, 1974, and assigned of record to General Signal Corporation.

The embodiment of this invention further includes a plurality of probes 20. The probes 20 are disposed to engage certain electrical leads printed on each of the dies 10 on the wafer 12. The probes 20 are included in electrical circuitry (not shown) for testing the electrical characteristics of the electrical circuitry provided on each of the dies 10. If the electrical circuitry on one of the dies 10 is not satisfactory, the testing apparatus may mark with a distinctive color the die being tested. The construction of an assembly of the probes 20 may be in accordance with the disclosure in United States Patent No. 3,835,381 issued to Oliver R. Garretson et al. on September 10, 1974, and assigned of record to General Signal Corporation.

A microcomputer 30 may be included for controlling the operation of the motor 16 in the coordinate directions. For example, the microcomputer may cause the motor 16 to step the flat bed 14 to successive positions in the X direction so that the dies of one row on the wafer 12 may be sequentially tested. After each such step, the microcomputer 30 may cause the probes 20 to become activated so that a test can be made on the electrical circuitry on the die. After the dies in one row on the wafer 12 have been sequentially tested in this manner, the wafer is stepped to the next row and tests are sequentially made on the dies in that row. The stepping of the wafer 12 to the dies in each successive row is illustrated by a broken line 64 in Figure 7. The stepping of the wafer 12 to the different dies in each row after the stepping of the wafer to that row is illustrated by a broken line 62 in Figure 7.

The embodiment of the invention shown in the drawings provides for the precise positioning of the dies 10 on the wafer 12 relative to the probes 20. By precisely positioning each of the dies sequentially relative to the probes 20, tests of the electrical circuitry on the dies more accurate than in the prior art can be made. This is particularly important because the complexity of the electrical circuitry on dies of a particular size have now become so great that tests of the electrical circuitry on the dies will be ineffective, or at least unreliable, unless the dies are precisely positioned relative to the probes 20.

A camera 40 is included in the embodiment of this invention. The camera 40 is fixedly positioned above the flat bed 14 to view only a limited portion of the bed. A television monitor 42 is also included in the embodiment of this invention to provide a visual monitor of the image viewed at each instant by the camera 40. The camera 40 and the television monitor 42 can be constructed in a conventional manner.

A pattern recognition unit 44 is also included in the embodiment of this invention. The pattern recognition unit may be obtained from View Engineering Corporation of Chatsworth, California. The pattern recognition unit 44 is connected to the camera 40 to convert the image in the camera into signals having a digital pattern representative of the characteristics of the image at each position being viewed by the camera. Such digital pattern may be binary or decimal or may be in any other form. When such digital pattern is binary, a binary "1" may represent a white position and a binary "0" may represent a dark position. The pattern recognition unit 44 also processes such digital signals to determine the distinctiveness of the image being viewed by the camera 40 at each instant.

In the practice of the invention, a first one of the wafers 12 in a plurality is disposed on the flat bed 14. The flat bed may then be moved manually by a joy stick 48 coupled to the flat bed 14 so that the camera 40 is able to scan different positions on the wafer. The portion of the wafer being scanned by the camera 40 at each instant may comprise an area less than the area of each die on the wafer.

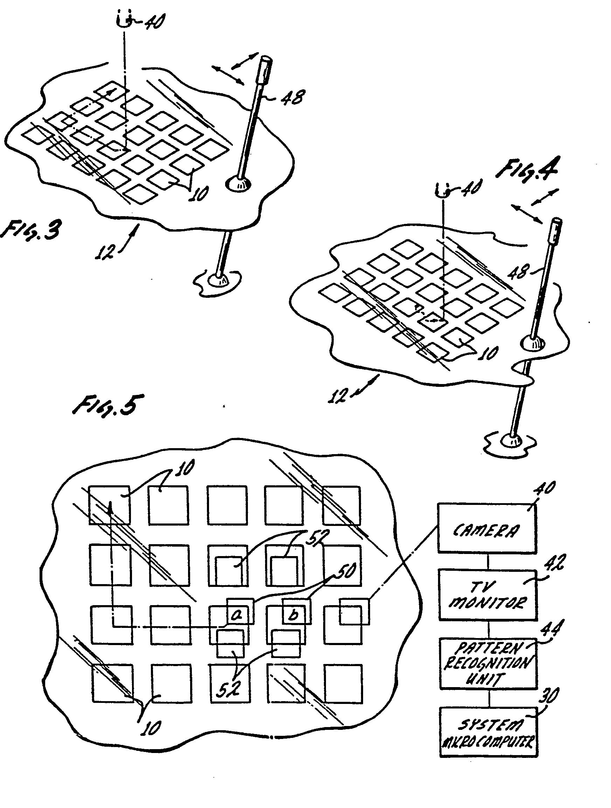

The image viewed by the camera 40 is visually presented on the monitor 42. As the flat bed is moved, the monitor 42 is visually scanned by the operator to select on the wafer a portion of the electrical circuitry which is distinctive. The distinctiveness of the scanned portion may result from the distinctive pattern of the electrical circuitry or from the spacings between adjacent dies or from a combination of distinctions in such circuitry and spacings or from other factors. Such a distinctive portion on the wafer 12 is schematically illustrated at 50 in Figure 5.

When the distinctive portion 50 of the wafer 12 has been selected, the pattern recognition unit 44 processes the signals representing this distinctive portion and produces an indication of the distinctiveness of this portion. A comparison is then made between this distinctive portion and portions of the image around this distinctive portion. This comparison is made by moving the flat bed 14 so that different portions 52 around the distinctive portion 50 may be visually scanned by the camera 40 and the signals from the camera may be processed by the system 44 to determine the distinctiveness of these portions. The portions 52 may be disposed relatively close to the portion 50.

The system 44 determines the distinctiveness of the intermediate portions 52 relative to the distinctive portion 50. Preferably the distinctiveness of the intermediate portions 52 should be relatively low in comparison to the distinctiveness of the portion 50. In this way, the distinctive portion 50 on successive ones of the wafers 12 in the plurality will be able to be distinguished easily from the area on the wafer around such distinctive portion.

After the distinctive portion 50 has been selected and its distinctiveness has been verified as discussed above, the wafer 12 is adjusted in position so that each row of dies 10 on the wafer is aligned along the X axis. The X-axis is indicated by broken lines 62 in Figure 7. This alignment is accomplished by comparing the distinctive portion 50 with portions on the wafer at progressive positions along the X axis. These portions are at positions displaced by particular distances from the distinctive portion 50 so that the distinctive portion 50 should be duplicated. These portions are illustrated at 50a and 50b in Figure 5.

The displacement of the wafer 12 to the portions at progressive positions is executed by the motor 16. The coordinates of the progressive positions are stored in a memory in the microcomputer system 30.

If the distinctiveness of the distinctive portion 50 is not substantially duplicated at the displaced positions such as the positions 50a and 50b, this indicates that the wafer 12 is angularly displaced from alignment of the rows of dies 10 on the wafer with the X axis. Under such circumstances, the flat bed 14 is rotated until the distinctiveness of the portions of the wafer at the displaced positions coincide substantially with the distinctiveness of the distinctive portion 50. By providing such adjustments after tests at progressive positions along the X axis, progressive refinements are made in the rotary disposition of the wafer 12.

The tests discussed in the previous paragraph are made by the pattern recognition unit 44 and the microcomputer 30. The system determines the distinctiveness of the image on the wafer 12 at each displaced position and compares this distinctiveness with the distinctiveness of the image in the distinctive portion 50. If the comparative distinctiveness do not have a substantial identity, the system 30 causes a motor 60 to drive a lead screw 63 which rotates the flat bed 14. As the flat bed 14 is rotated, the system 30 scans different portions of the wafer to establish substantial coincidence in the distinctiveness of these portions in comparison to the distinctiveness of the distinctive portion 50.

Although the testing of portions of the wafer at progressive positions along the X axis to align the rows of dies along this axis has been described above, alignment can also be essentially accomplished by making tests of adjacent portions on the wafer or portions considerably displaced from each other such as at opposite ends of the wafer. These opposite ends are preferably aligned along the X axis. However, the alignment of the wafer along the X axis may not be quite as precise by tests at adjacent positions, or even at opposite ends, as the alignment produced from tests at progressive positions along the X axis as described above.

After the rows of dies 10 on the wafer 12 have been aligned along the X axis, the joy stick 48 is used to move the area viewed by the camera from the distinctive portion 50 to a starting position on the wafer. This starting position may correspond to the die in the upper left corner of the wafer 12. The joy stick is used to move the wafer to this position. The starting coordinates are stored in a memory in the microcomputer system 30. The starting coordinates represent the disposition of the starting position relative to the distinctive portion 50.

Successive ones of the wafers 12 in the plurality are then introduced to the flat bed 14. When each of the wafers 12 is introduced to the flat bed, it is at a position approximately corresponding to the position of the distinctive portion 50. As a first step after the introduction of each such wafer to the flat bed 14, the camera 40 scans the wafer 12 and the pattern recognition unit 44 processes the signals representing the image being scanned and determines the distinctiveness of such image. If such distinctiveness does not coincide substantially with the distinctiveness of the distinctive portion 50, the system 30 causes the flat bed 14 to be adjusted in position to locate the distinctive portion 50. The distinctive portion 50 on the wafer is located by obtaining a substantial coincidence between the distinctiveness of the image being scanned by the camera 40 and the distinctive quality of the digital signals stored in the pattern recognition unit 44 to represent the distinctiveness 50 of the reference wafer.

After the distinctive portion 50 has been located on each of the wafers 12, tests are made as described above to align the rows of dies 10 on the wafer 12 along the X axis. This is accomplished by comparing the distinctiveness of the distinctive portion 50 on the wafer and the distinctiveness of portions of the wafer at different positions along the X axis. If a substantial coincidence in the distinctiveness of the compared portions does not exist, the flat bed 14 is rotated to obtain such a coincidence.

Upon an alignment of the rows of dies 10 on each wafer along the X axis, the microcomputer 30 causes via the motor 16 the flat bed 14 to be displaced to the starting position. A test of the successive dies 10 on the wafer 12 is then initiated. This test is effectuated by activating the probes 20 and determining the characteristics of the signals produced by the test circuitry when the probes 20 are activated. The flat bed 14 is then moved to the next die 10 along the X-axis 62 and the probes 20 are thereafter activated. After all of the dies in one of the rows on the X-axis have been tested, the flat bed 10 is moved along the Y-axis to present the next row of dies on the X-axis for testing. The Y-axis is indicated by broken lines at 64 in Figure 7.

The apparatus and methods described above have certain important advantages. They provide for a precise positioning of each wafer before tests on the circuitry on the dies in the wafer are initiated. They further provide for such precise positioning in a minimal amount of time and with a minimal margin for error. The apparatus and method are particularly advantageous because the dies on the wafer are so small and because the apparatus and method amplify, as a practical matter, the distinctive portion 50 of the wafer and use the distinctive characteristics of this portion as a reference to position the successive wafers in the plurality.

Sometimes the dies 10 on the wafer 12 are relatively large, as illustrated in Figure 8. Under such circumstances, the area being scanned by the camera 40 is considerably less than the area of each of the dies 10. Under such circumstances, progressive areas are scanned as at 82, 84, 86 and 88 to select a portion which will constitute the distinctive portion 50. As will be seen, each of the portions 82, 84, 86 and 88 preferably includes an individual portion of the die 10 and may also include a portion of the street between adjacent dies. Such a street is illustrated at 90 in Figure 8.

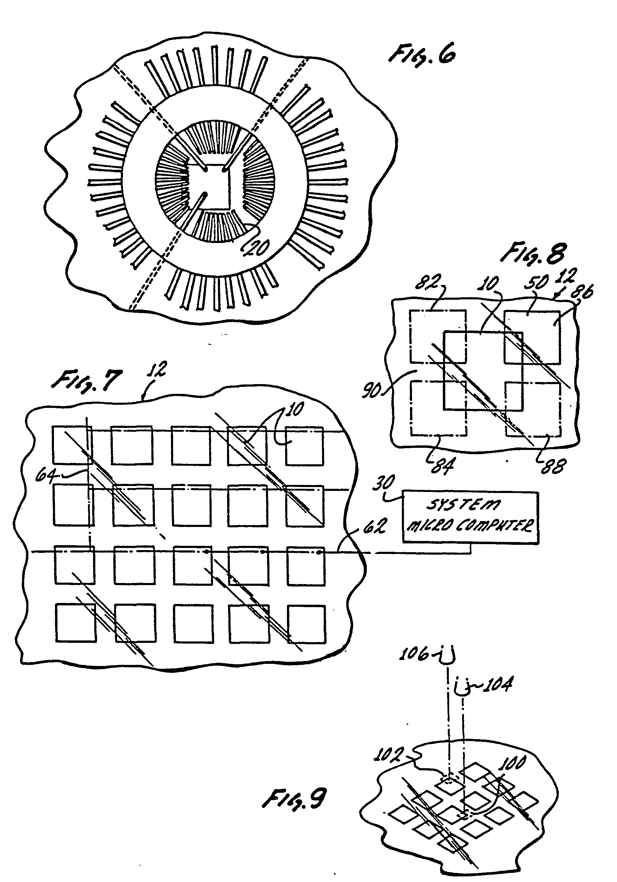

Figure 9 illustrates a method of, and apparatus for, practicing an extension of the invention. In the embodiment of Figure 9, a distinctive portion 100 is selected and located by a camera system 104 in the manner described above. The wafer is then rotated about a preselected fulcrum which may be within the distinctive portion 100 or may be outside of such distinctive portion. The rotation is continued until a distinctive portion 102 is aligned with a pattern prerecorded in the pattern recognition unit. This is accomplished by a camera system 106. In this way, the wafer is positioned to provide the precision operations as described above.

**Claims**

1. A method of positioning each wafer of a plurality of wafers, using a flat bed for supporting the wafer, to perform precision operations on the wafer thereafter where each of the wafers in the plurality has a plurality of printed dies disposed in at least one row and each die in the at least one row has a corresponding image, characterized by the following steps:
    i) placing a first wafer on the flat bed,
    ii) scanning an image of a particular wafer portion comprising at least a part of one die to use as a reference portion distinctive in image structure from portions around the reference portion and providing and storing an indication of the distinctiveness of the image structure of the reference portion relative to the portions around it,
    iii) aligning the row of dies along a particular axis by comparison of the distinctiveness of the image structure of the reference portion with that of a corresponding portion of another die of the row and angularly displacing the wafer until the distinctiveness of the reference portion and the said corresponding portion are substantially corresponding,
    iv) moving the wafer to a starting position by adjusting the flat bed position and storing the coordinates of the starting position with respect to the coordinates of the position of the reference portion,
    v) performing the precision operations on at least one die on the wafer,
    vi) removing the first wafer and placing a second one on the flat bed,
    vii) scanning an image of a portion of the second wafer approximately corresponding to the said reference portion and providing and storing an indication of the distinctiveness of the image structure of the scanned portion,
    viii) comparing the distinctiveness of the image structure of the scanned portion with the distinctiveness of the image structure of the reference portion,
    ix) adjusting the position of the second wafer by adjusting the flat bed position to obtain a substantial correspondence between the distinctiveness of the image structure of the reference portion and the portion being scanned on the second wafer,
    x) aligning the wafer according to iii),
    xi) displacing the second wafer to the starting position in accordance with the stored coordinates of the starting position,
    xii) performing the precision operations on at least one die on the second wafer,
    xiii) repeating steps vi) to xii) for each wafer of the plurality of wafers.

2. A method according to claim 1, characterized in that the precision operation involves the testing of electrical circuitry on each die to determine if such electrical circuitry meets preselected standards.

3. A method according to claim 1 or claim 2, characterized in that the scanning is provided by a television camera displaced from the bed.

4. Apparatus for carrying out the method according to claim 1, characterized by
    i) means for placing a first wafer on the flat bed,
    ii) means for scanning the reference portion of the first wafer and the portions around the reference portion and for determining the image structure of the reference portion and the portions around the particular portion,
    iii) means for comparing the image structure of the reference portion with those of the portions around the reference portion to establish the distinctiveness of the image structure of the reference portion,

iv) means for storing the said distinctiveness of the image structure of the reference portion,

v) means for comparing the distinctiveness of the image structure of the reference portion with the distinctiveness of the image structure of the corresponding portion of the dies in the row displaced from the reference portion,

vi) means for rotating the first wafer to make the distinctiveness of the image structure of the displaced portion correspond with the distinctiveness of the image structure of the reference portion,

vii) means for obtaining a movement of the first wafer to the starting position,

viii) means for storing the coordinates of the starting position with respect to the coordinates of the position of the reference portion,

ix) means for removing the first wafer from the flat bed, and placing on the flat bed each of the successive wafers in the plurality,

x) means for scanning an image of a portion on each of the successive wafers approximately corresponding to the said reference portion and for storing an indication of the distinctiveness of the image structure of the scanned portion,

xi) means for comparing the distinctiveness of the image structure of the portion scanned on each of the successive wafers in the plurality with the distinctiveness of the image structure stored from the first wafer and for adjusting the position of the portion being scanned on each of the successive wafers to obtain a substantial correspondence in the distinctiveness of the image structure between the portion being scanned on such wafer and the reference portion on the first wafer,

xii) means for rotating the successive wafers according to vi),

xiii) means for moving the flat bed to the starting position for each of the successive wafers in the plurality in accordance with the stored coordinates representing the difference in coordinates between the position of the reference portion and the starting position on the first wafer,

xiv) means for moving the flat bed to successive dies on each other of the wafers in the plurality, and

xv) means for obtaining a precision operation on each of the successive dies on each of the successive wafers in the plurality.

5. Apparatus according to claim 4, characterized in that the scanning means includes a camera.

6. Apparatus according to claim 4 or claim 5, characterized in that the means for scanning the reference portion and the portions around the reference portion include means for moving the flat bed relative to the scanning means in a first and a second coordinate direction.

7. Apparatus according to any of claims 4 to 6, characterized in that the means for moving the flat bed relative to the scanning means include a first motor operative to move the bed in the first direction and a second motor operative to move the bed in the second direction.

8. Apparatus according to any of claims 4 to 7, characterized in that the means for obtaining the precision operation provides tests on the operability of the dies being tested.

**Patentansprüche**

1. Verfahren zum Positionieren jeder Platte einer Mehrzahl von Platten, wobei zum Tragen der Platte ein Flachbett verwendet wird, so daß danach Präzisionsarbeiten an der Platte durchgeführt werden können, wobei auf jeder der Platten der Mehrzahl derselben eine Mehrzahl von gedruckten Bildträgern in mindestens einer Reihe angeordnet sind, und jeder Bildträger des mindestens einen Reihe ein entsprechendes Bild besitzt, gekennzeichnet durch folgende Schritte:

i) Eine erste Platte wird auf das Flachbett gelegt;

ii) es wird ein Bild eines bestimmten Plattenteils abgetastet, der mindestens einen Teil eines Bildträgers als einen Bezugsteil enthält, der sich in seiner Bildstruktur von den Bezugsteil umgebenden Teilen unterscheidet; und es wird eine Anzeige der Eigenart der Bildstruktur des Bezugsteils gegenüber der Bildstruktur der ihn umgebenden Teile erzeugt und gespeichert;

iii) zum Ausrichten der Reihe der Bildträger mit einer bestimmten Achse wird die Eigenart der Bildstruktur des Bezugsteils mit der eines entsprechenden Teils eines anderen Bildträgers der Reihe verglichen und die Platte gedreht, bis die Eigenart des Bezugsteils und die des genannten entsprechenden Teils im wesentlichen übereinstimmen;

iv) zum Bewegen der Platte in eine Ausgangsposition wird das Flachbett verstellt, und auf die Koordinaten der Position des Bezugsteils bezogenen Koordinaten der Ausgangsposition werden gespeichert;

v) an mindestens einem Bildträger der Platte werden die Präzionsarbeiten durchgeführt;

vi) die erste Platte wird entfernt und eine zweite Platte wird auf das Flachbett gelegt;

vii) ein Bild eines dem genannten Bezugsteil annähernd entsprechenden Teils der zweiten Platte wird abgetastet, und eine Anzeige der Eigenart der Bildstruktur des abgetasteten Teils wird gespeichert;

viii) die Eigenart der Bildstruktur des abgetasteten Teils wird mit der Eigenart der Bildstruktur des Bezugsteils verglichen;

ix) zum Positionieren der zweiten Platte wird das Flachbett so eingestellt, daß die Eigenarten der Bildstrukturen des Bezugsteils und des abgetasteten Teils der zweiten Platte einander im wesentlichen entsprechen;

x) die Platte wird gemäß iii) ausgerichtet;

xi) die zweite Platte wird entsprechend den gespeicherten Koordinaten der Ausgangsposition in die Ausgangsposition verschoben;

xii) an mindestens einem Bildträger der zweiten Platte werden die Präzisionsarbeiten durchgeführt;

xiii) die Schritte vi) bis xii) werden für jede Platte der Mehrzahl von Platten wiederholt.

2. Verfahren nach Anspruch 1, dadurch gekennzeichnet, daß zu den Präzisionsarbeiten das Prüfen der elektrischen Schaltung auf jedem Bildträger zwecks Feststellung der Erfüllung vorgewählter Normen durch diese Schaltung gehört.

3. Verfahren nach Anspruch 1 oder 2, dadurch gekennzeichnet, daß die Abtastung mit einer im Abstand von dem Bett angeordneten Fernsehkamera durchgeführt wird.

4. Vorrichtung zum Durchführen des Verfahrens nach Anspruch 1, gekennzeichnet durch

i) eine Einrichtung zum Auflegen einer ersten Platte auf das Flachbett;

ii) eine Einrichtung zum Abtasten des Bezugsteils der ersten Platte und der den Bezugsteil umgebenden Teile und zum Erfasser der Bildstruktur des Bezugsteils und der ihn umgebenden Teile;

iii) eine Einrichtung zum Vergleich der Bildstruktur des Bezugsteils mit den Bildstrukturen der den Bezugsteil umgebenden Teile zwecks Erfassung der Eigenart der Bildstruktur des Bezugsteils;

iv) eine Einrichtung zum Speichern der genannten Eigenart der Bildstruktur des Bezugsteils;

v) eine Einrichtung zum Vergleich der Eigenart der Bildstruktur des Bezugsteils mit der Eigenart der Bildstruktur des entsprechenden Teils der Bildträger in der im Abstand von dem Bezugsteil angeordneten Reihe;

vi) eine Einrichtung zum Drehen der ersten Platte derart, daß die Eigenart der Bildstruktur des im Abstand angeordneten Teils der Eigenart der Bildstruktur des Bezugsteils entspricht;

vii) eine Einrichtung zum Bewegen der ersten Platte in die Ausgangsposition;

viii) eine Einrichtung zum Speichern der auf die Koordinaten der Position des Bezugsteils bezogenen Koordinaten der Ausgangsposition;

iv) eine Einrichtung zum Abnehmen der ersten Platte von dem Flachbett und zum Auflegen der mehreren Platten der Mehrzahl einzeln nacheinander auf das Flachbett;

x) eine Einrichtung zum Abtasten jeder der aufeinanderfolgenden Platten in einem dem Bezugsteil annähernd entsprechenden Teil und zum Speichern einer Anzeige der Eigenart der Bildstruktur des abgetasteten Teils;

xi) eine Einrichtung zum Vergleich der Eigenart der Bildstruktur des abgetasteten Teiles jeder der aufeinanderfolgenden Platten mit der gespeicherten Eigenart der Bildstruktur der ersten Platte und zum Positionieren des abgetasteten Teils jeder der aufeinanderfolgenden Platten derart, daß die Eigenart der Bildstruktur des abgetasteten Teils dieser Platte der Eigenart der Bildstruktur des Bezugsteils der ersten Platte annähernd entspricht;

xii) eine Einrichtung zum Drehen der aufeinanderfolgenden Platten gemäß vi);

xiii) eine Einrichtung zum Bewegen des Flachbettes in die Ausgangsstellung für jede der aufeinanderfolgenden Platten entsprechend den gespeicherten Koordinaten, die die Koordinatendifferenz zwischen der Position des Bezugsteils und der Ausgangsposition der ersten Platte darstellen;

xiv) eine Einrichtung zum Positionieren aufeinanderfolgender Bildträgern jeder der anderen Platten der Mehrzahl durch Bewegen des Flachbetts;

xv) eine Einrichtung zum Durchführen einer Präzisionsarbeit an jedem der aufeinanderfolgenden Bildträger jeder der aufeinanderfolgenden Platten der Mehrzahl.

5. Vorrichtung nach Anspruch 4, dadurch gekennzeichnet, daß die Abtasteinrichtung eine Kamera umfaßt.

6. Vorrichtung nach Anspruch 4 oder 5, dadurch gekennzeichnet, daß die Einrichtung zum Abtasten des Bezugsteils und der den Bezugsteil umgebenden Teile eine Einrichtung umfaßt, die dazu dient, das Flachbett relativ zu der Abtasteinrichtung in einer ersten und einer zweiten Koordinatenrichtung zu bewegen.

7. Vorrichtung nach einem der Ansprüche 2 bis 6, dadurch gekennzeichnet, daß die Einrichtung zum Bewegen des Flachbetts relativ zu der Abtasteinrichtung einen ersten Motor zum Bewegen des Bettes in der ersten Richtung und einen zweiten Motor zum Bewegen des Bettes in der zweiten Richtung umfaßt.

8. Vorrichtung nach einem der Ansprüche 4 bis 7, dadurch gekennzeichnet, daß die Einrichtung zum Durchführen der Präzisionsarbeit zum Prüfen der Funktionsfähigkeit der geprüften Bildträger geeignet ist.

**Revendications**

1. Procédé de positionnement de chaque pastille d'une pluralité de pastilles, moyennant l'utilisation d'un support plat destiné à supporter la pastille, de manière à réaliser ultérieurement des opérations de précision sur cette pastille, chacune des pastilles de la pluralité de pastilles comportant plusieurs des imprimés disposés selon au moins une rangée et chaque dé de cette rangée possédant une image correspondante, caractérisé par les phases opératoires suivantes:

i) disposer une première pastille sur le support plat,

ii) explorer par balayage une image d'une partie particulière d'une pastille incluant au moins une partie d'un dé destinée à être utilisée en tant que partie de référence distincte, dans la structure de l'image, de parties situées autour de la partie de référence et délivrer et mémoriser une indication du caractère distinctif de la structure de l'image de la partie de référence par rapport aux parties qui l'entourent,

iii) aligner la rangée de dés suivant un axe particulier sur la base de la comparaison du caractère distinctif de la structure de l'image de la partie de référence à celui d'une partie correspondante d'un autre dé de la rangée, et déplacer angulaire-

0 037 663

ment la pastille jusqu'à ce que les caractères distinctifs de la partie de référence et de ladite partie correspondante se correspondent de façon substantielle,

iv) amener la pastille jusqu'à une position de départ en réglant la position du support plat et en mémorisant les coordonnées de la position de départ par rapport aux coordonnées de la position de la partie de référence,

v) exécuter les opérations de précision sur au moins un dé situé sur la pastille,

vi) retirer la première pastille et placer une seconde pastille sur le support plat,

vii) explorer par balayage une image d'une partie de la seconde pastille correspondant approximativement à ladite pastille de référence et délivrer et mémoriser une indication du caractère distinctif de la structure de l'image de la partie balayée,

viii) comparer le caractère distinctif de la structure de l'image de la partie balayée au caractère distinctif de la structure de l'image de la partie de référence,

ix) régler la position de la seconde pastille au moyen du réglage de la position du support plat de manière à obtenir une correspondance substantielle entre les caractères distinctifs de la structure de l'image de la partie de référence et de la partie explorée par balayage suivant la seconde pastille,

x) aligner la pastille conformément à iii),

xi) amener la seconde pastille jusqu'à la position de départ conformément aux coordonnées mémorisées de cette position,

xii) exécuter les opérations de précision sur au moins un dé situé sur la seconde pastille,

xiii) répéter les phases opératoires vi) à xii) pour chaque pastille de la pluralité des pastilles.

2. Procédé suivant la revendication 1, caractérisé en ce que l'opération de précision implique l'essai du circuit électrique situé sur chaque dé de manière à déterminer si un tel circuit satisfait à des normes présélectionnées.

3. Procédé selon la revendication 1 ou 2, caractérisé en ce que l'exploration par balayage est prévue au moyen du déplacement d'une caméra de télévision par rapport au support.

4. Appareil pour la mise en oeuvre du procédé selon la revendication 1, caractérisé par:

i) des moyens pour disposer une première pastille sur le support plat,

ii) des moyens pour explorer par balayage la partie de référence de la première pastille et les parties situées autour de la partie de référence et pour déterminer la structure de l'image de la partie de référence et des parties situées autour de la partie particulière,

iii) des moyens pour comparer la structure de l'image de la partie de référence à celle des parties situées autour de la partie de référence afin d'établir le caractère distinctif de la structure de l'image de la partie de référence,

iv) des moyens pour mémoriser ledit caractère distinctif de la structure de l'image de la partie de référence,

v) des moyens pour comparer le caractère distinctif de la structure de l'image de la partie de référence au caractère distinctif de la structure de l'image de la partie correspondante des dés situés dans la rangée, écartée de la partie de référence,

vi) des moyens pour entraîner en rotation la première pastille afin que le caractère distinctif de la structure de l'image de la partie déplacée corresponde au caractère distinctif de la structure de l'image de la partie de référence,

vii) des moyens pour obtenir un déplacement de la première pastille en direction de la position de départ,

viii) des moyens pour mémoriser les coordonnées de la position de départ par rapport aux coordonnées de la position de la partie de référence,

ix) des moyens pour retirer la première pastille du support plat et pour placer sur le support plat chacune des pastilles successives de la pluralité de pastilles,

x) des moyens pour explorer par balayage une image d'une partie située sur chacune des pastilles successives, qui correspond approximativement à ladite partie de référence, et pour mémoriser une indication du caractère distinctif de la structure de l'image de la partie explorée par balayage,

xi) des moyens pour comparer le caractère distinctif de la structure de l'image de la partie explorée par balayage sur chacune des pastilles successives de la pluralité de pastilles au caractère distinctif de la structure de l'image mémorisé à partir de la première pastille et pour régler la position de la partie qui est explorée par balayage sur chacune des pastilles successives afin d'obtenir une correspondance substantielle des caractères distinctifs de la structure de l'image entre la partie qui est explorée par balayage sur une telle pastille et la partie de référence située sur la première pastille,

xii) des moyens pour entraîner en rotation les pastilles successives conformément à vi),

xiii) des moyens pour déplacer le support plat en l'amenant dans la position de départ pour chacune des pastilles successives de la pluralité de pastilles conformément aux coordonnées mémorisées représentant la différence des coordonnées entre la position de la partie de référence et la position de départ sur la première pastille,

xiv) des moyens pour déplacer le support plat jusqu'à des dés successifs situés sur chacune des autres pastilles de la pluralité de pastilles, et

xv) des moyens pour réaliser une opération de précision sur chacun des dés successifs situés sur chacune desdites pastilles successives de la pluralité de pastilles.

5. Appareil selon la revendication 4, caractérisé en ce que les moyens d'exploration par balayage incluent un appareil de prise de vues.

6. Appareil selon la revendication 4 ou 5, caractérisé en ce que les moyens d'exploration par balayage de la partie de référence et des parties entourant la partie de référence incluent des moyens pour déplacer le support plat par rapport

9

aux moyens d'exploration par balayage suivant une première et une seconde directions de coordonnées.

7. Appareil selon l'une quelconque des revendications 4 à 6, caractérisé en ce que les moyens permettant de déplacer le support plat par rapport aux moyens de balayage incluent un premier moteur réagissant de manière à déplacer le support dans la première direction et un second moteur agissant de manière à déplacer le support dans la seconde direction.

8. Appareil selon l'une quelconque des revendications 4 à 7, caractérisé en ce que les moyens permettant de réaliser l'opération de précision réalisent des essais concernant le caractère fonctionnel des dés qui sont testés.

*Fig.1*

| SYSTEM MICRO COMPUTER | PATTERN RECOGNITION UNIT | TV MONITOR |
|---|---|---|
| 30 | 44 | 42 |

40

10

12

16

14

*Fig.2*

| SYSTEM MICRO COMPUTER |
|---|

30

60

16    63

10    12

40

14

| PATTERN RECOGNITION UNIT | TV MONITOR |
|---|---|
| 44 | 42 |

Fig.3

Fig.4

Fig.5

CAMERA 40

TV MONITOR 42

PATTERN RECOGNITION UNIT 44

SYSTEM MICRO COMPUTER 30

2

Fig.6

Fig.7

Fig.8

Fig.9

SYSTEM MICRO COMPUTER